# EUROPEAN PATENT APPLICATION

(11) **EP 1 688 965 A2**
(43) Date of publication of application: **09.08.2006**
(21) Application number: 06002073.2
(22) Date of filing: 01.02.2006
(51) Int. Cl.: H01B 3/40, H01B 3/12

(54) **Heatcurable dielectric resin composition and heatcurable dielectric resin film**

(30) Priority: 02.02.2005 JP 2005026619
(71) Applicant: Nippon Paint Co., Ltd., Osaka-shi, Osaka 531-8511 (JP)
(72) Inventor: Hayashi, Tadashi c/o Nippon Paint Co., Ltd., Osaka 572-8501 (JP); Namba, Osamu c/o Nippon Paint Co., Ltd., Osaka 572-8501 (JP)
(74) Representative: TER MEER - STEINMEISTER & PARTNER GbR

(57) **Abstract**

The invention relates to a heatcurable dielectric resin composition for preparing a flexible heatcurable dielectric resin film having an uncured state, the resin film comprising an epoxy resin A having a solid state at normal temperature and an epoxy resin B having a viscosity of 10 Pa·s or less at 25°C in a ratio (A : B) by weight of 25 : 75 to 75 : 25, and further comprising a dielectric ceramics in an amount of 20 to 80 vol% based on the total amount of the epoxy resins A and B.

## Description

### BACKGROUND OF THE INVENTION

### Field of the Invention

The invention relates to a heatcurable dielectric resin composition used to prepare a heatcurable dielectric resin film that has flexibility and put into an uncured state, and to a heatcurable dielectric resin film using this composition.

### Description of the Related Art

Many multilayer boards have come to be used as print wiring boards to cope with demands for the development of miniature, thin and highly densified electronic devices. A highly dielectric layer is formed as the interlayer or surface layer of the multilayer boards and utilized as a capacitor positively, thereby enabling the packaging density to be improved. However, conventional highly dielectric materials are ceramic sintered bodies obtained by molding a ceramic powder and by sintering the molded article and therefore, their dimensions and shapes are restricted by a molding method. Also, the sintered body has a high hardness and is fragile. Therefore, it is hard to process it freely and also it is not always easy to obtain a desired shape and a complicated shape.

In order to solve the above problem, attention is focused on a complex dielectric wherein inorganic dielectric particles are dispersed in a resin. In the publication of Japanese Patent Application Laid-Open No. 2002-356619, a heatcurable complex dielectric film is proposed which is obtained by compounding dielectric ceramics having a high dielectric constant in a heatcurable resin such as an epoxy resin having an epoxy equivalent of 150 to 2500 and which has flexibility.

However, when such a heatcurable complex dielectric film is used to form a capacitor, only insufficient strength is obtained and therefore, there is the case where the capacitor is less reliable.

As a method that solves the above problem, a method using an epoxy resin having an epoxy equivalent of more than 2500 is considered. However, this method has the problem that when such an epoxy resin is used to form a heatcurable complex dielectric film, only sufficient flexibility is obtained.

### SUMMARY OF THE INVENTION

It is an object of the present invention to provide a heatcurable dielectric resin composition enabling the preparation of a heatcurable dielectric resin film which is superior in handling characteristics in an uncured state and has flexibility enough to obtain high workability when it is incorporated into a substrate and can stand to use after cured, showing that it is highly reliable, and also to provide a heatcurable dielectric resin film formed using the composition.

A heatcurable dielectric resin composition according to the present invention is one used to prepare a heatcurable dielectric resin film having an uncured state with flexibility. The heatcurable dielectric resin composition comprises an epoxy resin A having a solid state at normal temperature and a liquid epoxy resin B having a viscosity of 10 Pa·s or less at 25°C in a ratio (A : B) by weight of 25 : 75 to 75 : 25, and further comprises a dielectric ceramic in an amount of 20 to 80 vol% based on the total amount of the epoxy resins A and B.

In the present invention, a combination of the epoxy resin A having a solid state at normal temperature and the liquid epoxy resin B having a viscosity of 10 Pa·s or less at 25°C is used to produce a heatcurable dielectric resin composition. When this heatcurable dielectric resin composition is molded into a film, it is made into a heatcurable dielectric resin film which is superior in handling characteristics in an uncured state and has flexibility enough to obtain high workability when it is incorporated into a substrate and can stand to use after cured, showing that it is highly reliable.

In the present invention, the mixing ratio by weight of the epoxy resin A to the epoxy resin B (A : B) is 25 : 75 to 75 : 25. If the content of the epoxy resin B is less than the above range, there is the case where only insufficient flexibility is obtained when it is molded into a film. Also, if the content of the epoxy resin B is too high, there is the case where it is impossible to mold into a film.

The epoxy resins A and B and the dielectric ceramics will be explained in detail.

### <Epoxy resin A>

As the epoxy resin A, an epoxy resin having a glass transition point of 40°C or more is preferable. When the glass transition point is less than 40°C, there is the case where the epoxy resin is not put into a solid state at normal temperature (20°C). If an epoxy resin having a grass transition temperature less than 40°C is used, there is the case where when the obtained dielectric resin composition is made into a film, the strength of the film is insufficient. The glass transition point is more preferably 60°C or more.

The epoxy equivalent of the epoxy resin A preferably exceeds 2500. When the epoxy equivalent is 2500 or less, there is the case where the fragility caused when the obtained dielectric resin film is hardened adversely affects the reliability. The epoxy equivalent is more preferably in a range from 5000 to 100000.

As the epoxy resin A, any epoxy resin may be used insofar as it has a solid state at normal temperature. Examples of the epoxy resin A include glycidyl ether type epoxy resins such as glycidyl ether of bisphenol A, glycidyl ether of bisphenol F, glycidyl ether of bisphenol AD, glycidyl ether of resorcin, glycidyl ether of glycerin, glycidyl ether of polyalkylene oxide and glycidyl ether of brominated bisphenol A and their oligomers; epoxidized compounds of condensates between, phenols, orthocresols and/or naphthols, and formalins, aliphatic or aromatic aldehydes, or ketones as represented by glycidyl ether of phenol novolac; stilbene type epoxy resins; biphenyl type epoxy resins; alicyclic epoxy resins, for example, alicyclic diepoxyacetal, alicyclic diepoxyadipate and alicyclic diepoxycarboxylate; and chain aliphatic epoxy resins represented by epoxidized polybutadiene. Also, examples of other epoxy resins include glycidyl ester type epoxy resins such as diglycidyl phthalate, diglycidyl tetrahydrophthalate and diglycidyl hexahydrophthalate, glycidylamine type epoxy resins, for example, N,N-diglycidylaniline, tetraglycidylaminophenylmethane, heterocyclic epoxy resins, hydantoin type epoxy resins, triglycidylisocyanurate, silicone-modified epoxy resins, urethane-modified epoxy resins and polyimide or polyamide-modified epoxy resins. These epoxy resins may be used in combinations of two or more.

As the epoxy resin A, commercially available epoxy resins may be used either singly or in combinations of two or more. Examples of the commercially available products of the epoxy resin include the following compounds.

### 1. Epoxy resins manufactured by Tohto Kasei Co., Ltd. (trade name: "Epototo")

### (i) BPA type epoxy resins

YD-011 (epoxy equivalent: 450 to 500), YD-012 (epoxy equivalent: 600 to 700), YD-013 (epoxy equivalent: 800 to 900), YD-014 (epoxy equivalent: 900 to 1,000), YD-017 (epoxy equivalent: 1,750 to 2,100), YD-019 (epoxy equivalent: 2,400 to 3,300), YD-7011R (epoxy equivalent: 460 to 490), YD-7014R (epoxy equivalent: 850 to 880), YD-901 (epoxy equivalent: 450 to 500), YD-902 (epoxy equivalent: 600 to 700), YD-903N (epoxy equivalent: 780 to 840), YD-904 (epoxy equivalent: 900 to 1,000), YD-907 (epoxy equivalent: 1,300 to 1,700), YD-909 (epoxy equivalent: 1,800 to 2,500), YD-7910 (epoxy equivalent: 2,400 to 3,000) and YD-6020 (epoxy equivalent: 3,000 to 5,000).

### (ii) Brominated epoxy resins

YDB-360 (epoxy equivalent: 350 to 370), YDB-400 (epoxy equivalent: 380 to 420) and YDB-405 (epoxy equivalent: 530 to 630).

### (iii) Hydrogenated BPA type epoxy resins

ST-4000D (epoxy equivalent: 650 to 750).

### (iv) BPF epoxy resins

YDF-2001 (epoxy equivalent: 450 to 500) and YDF-2004 (epoxy equivalent: 900 to 1,000).

### (v) Novolac type epoxy resins

YDCN-701 (epoxy equivalent: 195 to 220), YDCN-702 (epoxy equivalent: 195 to 220), YDCN-703 (epoxy equivalent: 195 to 220), YDCN-704 (epoxy equivalent: 195 to 220) and YDCN-704L (epoxy equivalent: 207 to 215).

### (vi) Epoxy resins for molding

YC-195N (epoxy equivalent: 370 to 420).

### (vii) Crystalline epoxy resins

YDC-1312 (epoxy equivalent: 170 to 185), YSLV-80XY (epoxy equivalent: 180 to 210) and YSLV-120TE (epoxy equivalent: 235 to 255).

### (viii) Phenoxy resins

YP-50 (Mw: 60,000 to 80,000), YP-50S (Mw: 50,000 to 70,000, hydroxyl value: 322 to 241), YP-55 (epoxy equivalent: 10,000 to 20,000, Mw: 50,000 to 60,000), YP-70 (epoxy equivalent: 11,000 to 17,000, Mw: 50,000 to 60,000), YPS-007 (Mw: 35,000, resin Tg: 130°C), FX-278 (resin Tg: 154°C), FX-280 (Mw: 38,000, resin Tg: 152°C), FX-280S (epoxy equivalent: 17,500, Mw: 45,000, hydroxyl value: 349 to 300, resin Tg: 158°C), FX-281 (Mw: 45,000, hydroxyl value: 353 to 316, resin Tg: 165°C), FX-281S (Mw: 69,000, resin Tg: 168°C), FX-293 (epoxy equivalent: 15,000, Mw: 44,000, resin Tg: 163°C),ERF-001 (epoxy equivalent: 17,000, Mw: 43,000, hydroxyl value: 337, resin Tg: 146°C) and ZX-1449 (epoxy equivalent: 8,500, Mw: 50,000 to 60,000).

### 2. Epoxy resins manufactured by Japan Epoxy Resins Co.,Ltd.

### (i) Phenoxy resins

E1255 (Mw: 490,000, resin Tg: 98°C), E1256 (epoxy equivalent: 7,800, Mw: 48,000, hydroxyl value: 309, resin Tg: 98°C), E4250 (epoxy equivalent: 8,200, Mw: 59,000, resin Tg: 78°C), E4256 (epoxy equivalent: 8,000, Mw: 57,000, resin Tg: 65°C), E4275 (epoxy equivalent: 9,000, Mw: 60,000, resin Tg: 75°C), E5580 (epoxy equivalent: 13,000, Mw: 31,000, resin Tg: 110°C), YX8100 (epoxy equivalent: 10,000 to 20,000, Mw: 38,000, hydroxyl value: 316, resin Tg: 150°C), YL6954 (epoxy equivalent: 12,000, Mw: 39,000, hydroxyl value: 334, resin Tg: 130°C), YL7165 (epoxy equivalent: 10,290, Mw: 53,000, resin Tg: 48°C).

### (ii) BPA type epoxy resins

1001 (epoxy equivalent: 450 to 500), 1002 (epoxy equivalent: 600 to 700), 1003 (epoxy equivalent: 670 to 770), 1055 (epoxy equivalent: 800 to 900), 1004 (epoxy equivalent: 875 to 975), 1007 (epoxy equivalent: 1,750 to 2,200), 1009 (epoxy equivalent: 2,400 to 3,300), 1010 (epoxy equivalent: 3,000 to 5,000), 1005F (epoxy equivalent: 950 to 1,050), 1100L (epoxy equivalent: 3,000 to 5,000), YL6810 (epoxy equivalent: 172), E1016 (epoxy equivalent: 1,430), E5560 (epoxy equivalent: 2,800, Mw: 15,000).

### (iii) Biphenyl type epoxy resins

YX4000H (epoxy equivalent: 193), YL6121H (epoxy equivalent: 171).

### 3. Epoxy resins manufactured by Daicel Chemical Industries, Ltd.

A1005 (epoxy equivalent: 1,800 to 2,100), A1010 (epoxy equivalent: 950 to 1,050), A1020 (epoxy equivalent: 480 to 540).

### 4. Epoxy resins manufactured by Dainippon Ink and Chemicals, Incorporated

### (i) BPA type epoxy resins

1050 (epoxy equivalent: 450 to 500), 1055 (epoxy equivalent: 450 to 500), 2055 (epoxy equivalent: 600 to 670), 3050 (epoxy equivalent: 740 to 860), 4050 (epoxy equivalent: 900 to 1,000), 4055 (epoxy equivalent: 875 to 975), 7050 (epoxy equivalent: 1,750 to 2,100), 7051 (epoxy equivalent: 1,750 to 2,200), 9055 (epoxy equivalent: 2,400 to 3,100), AM-020-P (epoxy equivalent: 600 to 670), AM-030-P (epoxy equivalent: 710 to 780), AM-040-P (epoxy equivalent: 890 to 970), HM-091 (epoxy equivalent: 2,200 to 2,900) and HM-101 (epoxy equivalent: 3,200 to 3,900).

### (ii) Phenoxy resins

H-360 (Mw: 25,000, hydroxyl value: 200), H-371-I (Mw: 33,000, hydroxyl value: 200), EXA-192 (Mw: 45,000, hydroxyl value: 200), EXA-123 (Mw: 45,000, hydroxyl value: 200) and H-380-25AP (Mw: 45,000, hydroxyl value: 200).

### (iii) Cresol novolac type epoxy resins

N-655 (epoxy equivalent: 200 to 230), N-655-EXP-S (epoxy equivalent: 197 to 207), N-660 (epoxy equivalent: 200 to 215), N-660-LE (epoxy equivalent: 200 to 210), N-662-EXP-S(epoxy equivalent: 200 to 210), N-665 (epoxy equivalent: 200 to 215), N-665-LE (epoxy equivalent: 200 to 210), N-665-XP (epoxy equivalent: 185 to 215), N-665-EXP (epoxy equivalent: 200 to 215), N-665-EXP-S (epoxy equivalent: 200 to 210), RDN-665-EXP (epoxy equivalent: 190 to 215), N-667 (epoxy equivalent: 200 to 220), N-670 (epoxy equivalent: 200 to 215), N-670-EXP (epoxy equivalent: 200 to 215), N-670-EXP-S (epoxy equivalent: 200 to 210), N-672-EXP (epoxy equivalent: 200 to 215), N-673 (epoxy equivalent: 200 to 215), N-673-80M (epoxy equivalent: 200 to 230), N-680 (epoxy equivalent: 200 to 220), N-680-75M (epoxy equivalent: 200 to 230), N-690 (epoxy equivalent: 210 to 240) and N-695 (epoxy equivalent: 205 to 225).

### (iv) Phenol novolac type epoxy resin

N-510 (epoxy equivalent: 170 to 200), N-770 (epoxy equivalent: 180 to 200), N-775 (epoxy equivalent: 180 to 200), N-865 (epoxy equivalent: 195 to 215), N-870 (epoxy equivalent: 195 to 215), EXA-1857 (epoxy equivalent: 230 to 260) and EXA-4506 (epoxy equivalent: 210 to 240).

### (v) Naphthalene type epoxy resin

EXA-4300L (epoxy equivalent: 225), EXA-4700 (epoxy equivalent: 162), EXA-4701 (epoxy equivalent: 167), EXA-4750 (epoxy equivalent: 189), EXA-7660 (epoxy equivalent: 350) and EXA-7670 (epoxy equivalent: 255).

### (vi) BPS type epoxy resin

EXA-1514 (epoxy equivalent: 300).

### (vii) Dicyclopentadiene type epoxy resin

HP-7200L (epoxy equivalent: 245 to 250), HP-7200 (epoxy equivalent: 255 to 260), HP-7200H (epoxy equivalent: 275 to 280) and HP-7200HH (epoxy equivalent: 275 to 280).

### (viii) Bisphenol F novolac type epoxy resin EXA-7376 (epoxy equivalent: 187).

### (ix) BPF type epoxy resin

EXA-9580 (epoxy equivalent: 360), EXA-9581 (epoxy equivalent: 430), EXA-9569 (epoxy equivalent: 900) and FQ-045 (epoxy equivalent: 1,150).

### (x) Isocyanate-modified epoxy resin

EXA-9583 (epoxy equivalent: 415).

### (xi) Phenol resin type epoxy resin

EXA-4580L (epoxy equivalent: 290 to 300), EXA-4580 (epoxy equivalent: 300 to 310) and EXA-4580H (epoxy equivalent: 305 to 315).

In the present invention, especially, a phenoxy resin having a weight average molecular weight of 25,000 or more is preferably used as the epoxy resin A. When the weight average molecular weight is less than 25,000, there is the case where the strength of a film formed of the obtained dielectric resin composition is insufficiently obtained.

Examples of the above phenoxy resin include resins obtained by reacting epichlorohydrin with a compound having two or more hydroxyl groups and one or more photo-reacting group in its molecule. The use of such a resin makes it possible to impart light-sensitivity to the obtained dielectric resin composition and enables patterning using a photographic method. Examples of the photo-reacting group include α,β-unsaturated ketone groups and benzophenone groups.

Examples of the compound having two or more hydroxyl groups and one or more photo-reacting groups in its molecule include the following compounds. Each melting point of these compounds is shown together.

4,4'-dihydroxybenzophenone: 213°C (photo-reacting group: benzophenone); and

4,4'-dihydroxydibenzalacetone: 237°C (photo-reacting group: α,β-unsaturated ketone group).

Other examples of the phenoxy resin include resins obtained by reacting epichlorohydrin with a compound having a melting point of 200°C or more and two or more hydroxyl groups in its molecule. If the melting point of the compound is less than 200°C, there is the case where the strength of a film formed of the compound is insufficiently obtained.

The compound having a hydroxyl group is reacted with epichlorohydrin to thereby introduce a glycidyl group into the part of a hydroxyl group.

Examples of the compound having a melting point of 200°C or more and two or more hydroxyl groups in its molecule may include the following compounds. Each melting point of these compounds is shown together.
4,4'-methylenebis[2,6-dibromophenol]: 204°C;
4,4'-methylenebis[2,3,6-trimethylphenol]: 212°C;
4,4'-ethylenebis[2-cyclohexyl-5-methylphenol]: 223°C;
4 ,4'- (1-methylethylene) bis [2-6-diiodophenol] : 252°C;
4,4'-butylidenebis[2-cyclohexyl-5-methylphenol]: 219°C;
4,4'-propylidenebis[2-cyclohexyl-5-methylphenol]: 219°C;
4,4'-(1-ethylpropylidene)bisphenol: 205°C
4,4'-(2-ethylhexylidene)bis[2-cyclohexyl-5-methylphenol]: 204°C;
4,4'-[1-(4-amino-phenyl)ethylidene]bisphenol] : 250°C;
4,4'-(3,4-dimethoxyphenylmethylene)bis[2-cyclohexyl-5-methylphenol] : 240°C;
4,4'-phenylmethylenebis[2-cyclohexyl-5-methylphenol]: 216°C;
4,4'-[4-(1-methylethyl)phenylmethylenebis[2-cyclohexyl]-5-methyl-phenol] : 221°C;
4,4'-(4-methyl-phenylmethylene)bis[2-cyclohexyl-5-methylphenol] : 211°C;
4,4'-(3,4,5-trimethoxy)phenylmethylenebis[2-cyclohexyl-5-methylphenol]: 231°C;
4,4'-(4-methoxyl-phenylmethylene)bis[2-cyclohexyl-5-methylphenol] : 210°C;
4,4'-(2-methoxyl-phenylmethylene)bis[2,3,5-trimethylphenol] : 257°C;
4,4'-[4-(1,1'-biphenyl)methylene]bis[2-cyclohexyl-5-methylphenol] : 203°C;
4,4'-dihydroxytetraphenylmethane: 300°C;
4,4'-(diphenyl-methylene)bis[2-fluorophenol]: 243°C;
4,4'-(diphenyl-methylene)bis[2,6-difluorophenol]: 214°C;
4,4'-(2methyl-propylidene)bis[3-methyl-6-(1,1-dimethylethyl)phenol] : 234°C;
4,4'-(1-methyl-propylidene)bis[2-cyclohexyl-5-methylphenol] : 244°C;
4,4'-cyclohexylidene-bis(2,6-dimethylphenol): 200°C;
4,4'-[4-(1-methyl-ethyl)cyclohexylidene]bis[2-methylphenol] : 219°C
4,4'-(9H-fluorene-9-iridene)bisphenol: 225°C;
4,4'-(9H-fluorene-9-iridene)bis[2-methylphenol]: 220°C;
4,4'-(9H-fluorene-9-iridene)bis[2-fluorophenol: 229°C;
4,4'-(9H-fluorene-9-iridene)bis[2,5-dimethylphenol]: 278°C;
4,4'-(9H-fluorene-9-iridene)bis[2,6-dimethylphenol]: 289°C;
4,4'-(9H-fluorene-9-iridene)bis[2-(1-methylethyl)phenol] : 227°C;
4,4'-(9H-fluorene-9-iridene)bis[2-(1,1-dimethylethyl)phenol: 248°C;
4,4'-(9H-fluorene-9-iridene)bis[2-phenylphenol: 266°C;
4,4'-[1,4-phenylenebismethylene]bis[2,3,6-trimethylphenol]: 210°C;
4,4'-[1,4-phenylenebis(1-methylethylidene)]bis[2,3,6-trimethylphenol]: 212°C;
4,4'-dihydroxy-biphenyl: 274°C;
4,4'-dihydroxy-3,3',5,5'-tetramethyl-biphenyl: 222°C;
4,4'-dihydroxy-2,2',3,3',5,5'-hexamethyl-biphenyl: 228°C;
Octafluoro-4,4'-biphenol: 207°C;
4,4'-bis(2-hydroxy-ethoxy)-biphenyl: 214°C;
[1,1'-bicyclohexene-3,3'-yl]-4,4'-bis[2,5-dimethylphenol] : 264°C;
1,1'-bis-2-naphthol: 214°C;
Bis(4-hydroxyphenyl)sulfone: 249°C
Bis(3,5-dimethyl-4-hydroxyphenyl)sulfone: 298°C;

In the present invention, the hydroxyl value of the phenoxy resin used as the epoxy resin A is preferably 200 or more. If the hydroxyl value is less than 200, there is the case where the strength of a film formed using the phenoxy resin is insufficiently obtained, and also the strength of a cured film is insufficiently obtained, which impairs the reliability of the film.

Also, the hydroxyl value is more preferably in a range from 250 to 400.

Also, the glass transition point of the phenoxy resin is preferably 120°C or more. When the glass transition point is less than 120°C, there is the case where the strength of a film formed using the phenoxy resin is insufficiently obtained.

### <Epoxy resin B>

The number of functional groups in the molecule of the epoxy resin B is preferably 2 or more. Also, the epoxy equivalent of the epoxy resin B is preferably 200 or less. If the epoxy equivalent exceeds 200, the strength of a cured film is insufficiently obtained, which makes the film less reliable.

Also, the epoxy equivalent of the epoxy resin B is more preferably in a range from 190 to 90.

As the epoxy resin B, any epoxy resin may be used without any particular limitation insofar as it is a liquid having a viscosity of 10 Pa·s or less at 25°C. Examples of the epoxy resin B include glycidyl ether type epoxy resins such as glycidyl ether of bisphenol A, glycidyl ether of bisphenol F, glycidyl ether of bisphenol AD, glycidyl ether of resorcin, glycidyl ether of glycerin, glycidyl ether of polyalkylene oxide and glycidyl ether of brominated bisphenol A and their oligomers; epoxidized compounds of condensates between phenols, orthocresols and/or naphthols, and formalins, aliphatic or aromatic aldehydes, or ketones as represented by glycidyl ether of phenol novolac; stilbene type epoxy resins; biphenyl type epoxy resins; alicyclic epoxy resins, for example, alicyclic diepoxyacetal, alicyclic diepoxyadipate, and alicyclic diepoxycarboxylate; and chain aliphatic epoxy resins represented by epoxidized polybutadiene. Also, examples of other epoxy resins include glycidyl ester type epoxy resins such as diglycidyl phthalate, diglycidyl tetrahydrophthalate and diglycidyl hexahydrophthalate, glycidylamine type epoxy resins, for example, N,N-diglycidylaniline, tetraglycidylaminophenylmethane, heterocyclic epoxy resins, hydantoin type epoxy resins, triglycidylisocyanurate, silicone-modified epoxy resins, urethane-modified epoxy resins and polyimide or polyamide-modified epoxy resins. These epoxy resins may be used in combinations of two or more.

As the epoxy resin B, commercially available epoxy resins may be used either singly or in combinations of two or more. Examples of the commercially available products of the epoxy resin include the following compounds.
1. Products produced by Japan Epoxy Resin Co., Ltd., (trade name: "Epicoat") 802 (number of functional groups: 2, epoxy equivalent: 190 to 205), 806 (number of functional groups: 2, epoxy equivalent: 165), 807 (number of functional groups: 2, epoxy equivalent: 170), 815 (number of functional groups: 2, epoxy equivalent: 181 to 191), 819 (number of functional groups: 2, epoxy equivalent: 180 to 220), 825 (number of functional groups: 2, epoxy equivalent: 175), 1750 (number of functional groups: 2, epoxy equivalent: 160), YL-6753 (number of functional groups: 2, epoxy equivalent: 190), YX8000 (number of functional groups: 2, epoxy equivalent: 205), YL983U (number of functional groups: 2, epoxy equivalent: 170), RXE21 (number of functional groups: 2, epoxy equivalent: 213) and YED216D (number of functional groups: 2, epoxy equivalent: 120).
2. Products produced by Mitsubishi Gas Chemical Company Inc.
   TETRAD-X/N,N,N',N'-tetraglycidyl m-xylenediamine (number of functional groups: 4, epoxy equivalent: 95 to 105) and TETRAD-C/1,3bis(N,N-diglycidylaminomethyl)cyclohexane (number of functional groups: 4, epoxy equivalent: 100 to 110).
3. Products produced by Sumitomo Chemical Co., Ltd.
   ELA-115 (number of functional groups: 2, epoxy equivalent: 180 to 194), ELA-115CA (number of functional groups: 2, epoxy equivalent: 195 to 215), ELA-117 (number of functional groups: 2, epoxy equivalent: 195 to 210), ELA-118 (number of functional groups: 2, epoxy equivalent: 190 to 210) and ELA-100 (number of functional groups: 3, epoxy equivalent: 107).
4. Products produced by Asahi Denka Kogyo K.K.
   ED-503 (number of functional groups: 2, epoxy equivalent: 165), ED-505 (number of functional groups: 3, epoxy equivalent: 150), ED-505R (number of functional groups: 3, epoxy equivalent: 135), ED-507 (number of functional groups: 3, epoxy equivalent: 145), ED-513 (number of functional groups: 2, epoxy equivalent: 150 to 180), ED-523 (number of functional groups: 2, epoxy equivalent: 140 to 160), ED-523T (number of functional groups: 2, epoxy equivalent: 140), ED-4085E (number of functional groups: 2, epoxy equivalent: 160), EP-4085S (number of functional groups: 2, epoxy equivalent: 145), EP-4088E (number of functional groups: 2, epoxy equivalent: 190), EP-4088S (number of functional groups: 2, epoxy equivalent: 170), EP-4400 (number of functional groups: 2, epoxy equivalent: 165 to 185), EP-4500A (number of functional groups: 2, epoxy equivalent: 165 to 185), EP-4510 (number of functional groups: 2, epoxy equivalent: 190 to 210), EP-4520 (number of functional groups: 2, epoxy equivalent: 195 to 215), EP-4520S (number of functional groups: 2, epoxy equivalent: 195 to 215) and EP-4530 (number of functional groups: 2, epoxy equivalent: 180 to 200).
5. Nagase Chemtex (K.K.) (trade name: "Dinacol"/"Denarex")
   EX-201/lithocinol diglycidyl ether (number of functional groups: 2, epoxy equivalent: 117), EX-211/neopentylglycol diglycidyl ether (number of functional groups: 2, epoxy equivalent: 138), EX-212L/1,6-hexanediol diglycidyl ether (number of functional groups: 2, epoxy equivalent: 135), EX-214L/1,4-butanediol diglycidyl ether (number of functional groups: 2, epoxy equivalent: 120), EX-216L/cyclohexanedimethanol diglycidyl ether (number of functional groups: 2, epoxy equivalent: 150), EX-313/glycerol polyglycidyl ether (number of functional groups: 2 to 3, epoxy equivalent: 141), EX-321/trimethylolpropane polyglycidyl ether (number of functional groups: 2 to 3, epoxy equivalent: 140), EX-421/diglycerol polyglycidyl ether (number of functional groups: 3, epoxy equivalent: 159), EX-512/polyglycerol polyglycidyl ether (number of functional groups: 2, epoxy equivalent: 168), EX-521/polyglycerol polyglycidyl ether (number of functional groups: 3, epoxy equivalent: 183), EX-614B/sorbitol polyglycidyl ether (number of functional groups: 4, epoxy equivalent: 173), EX-721/diglycidyl-o-phthalate (number of functional groups: 2, epoxy equivalent: 154), EX-810/ethylene glycol diglycidyl ether (number of functional groups: 2, epoxy equivalent: 113), EX-850/diethylene glycol diglycidyl ether (number of functional groups: 2, epoxy equivalent: 122), EX-821/polyethylene glycol diglycidyl ether (number of functional groups: 2, epoxy equivalent: 185), EX-911/propylene glycol diglycidyl ether (number of functional groups: 2, epoxy equivalent: 165), EX-941/dipropylene glycol diglycidyl ether (number of functional groups: 2, epoxy equivalent: 173) and EX-920/polypropylene glycol diglycidyl ether (number of functional groups: 2, epoxy equivalent: 176).
6. Products produced of Dainippon Ink and Chemicals, Incorporated
   (i) BPF type epoxy resins
      S-129 (number of functional groups: 2, epoxy equivalent: 165 to 185), 830 (number of functional groups: 2, epoxy equivalent: 165 to 180), 830-S (number of functional groups: 2, epoxy equivalent: 165 to 180), EXA-830CRP (number of functional groups: 2, epoxy equivalent: 159) and 835 (number of functional groups: 2, epoxy equivalent: 165 to 180).
   (ii) BPA type epoxy resins
      855 (number of functional groups: 2, epoxy equivalent: 183 to 193), 857 (number of functional groups: 2, epoxy equivalent: 190 to 205), EXA-850CRP (number of functional groups: 2, epoxy equivalent: 172) and EXA-7015 (number of functional groups: 2, epoxy equivalent: 200).
   (iii) Alkyldiphenol type epoxy resins
      EXA-7120 (number of functional groups: 2, epoxy equivalent: 214).
   (iv) Polyalkylene glycol type epoxy resins
      Epicron 705 (number of functional groups: 2, epoxy equivalent: 175 to 205) and Epicron 707 (number of functional groups: 2, epoxy equivalent: 300 to 340).

### <Dielectric ceramics>

In the present invention, a dielectric ceramics is compounded in an amount of 20 to 80 vol% based on the total amount of the epoxy resins A and B. If the content of the dielectric ceramics is too small, there is the case where the dielectric characteristics of the heatcurable dielectric resin film is insufficient whereas if the content of the dielectric ceramics is too large, there is the case where the flexibility of the heatcurable dielectric resin film is only insufficient.

As the dielectric ceramics, those having a dielectric constant of 200 or more when it is singly measured are preferable and particularly, a ferroelectric ceramics having a perovskite structure is preferably used. Examples of the dielectric ceramics used in the present invention include barium titanate (BaTiO₃), calcium titanate (CaTiO₃), strontium titanate (SrTiO₃), lead titanate type ceramics such as lead titanate (PbTiO₃) and PbTi_{1/2}Zr_{1/2}O₃, magnesium titanate type ceramics, bismuth titanate type ceramics, other metal titanate type ceramics, Pb (Mg_{2/3}Nb_{1/3})O₃, Ba(SnₓMg_{y}Ta_{z})O₃, Ba(ZrₓZn_{y}Ta_{z})O₃, TiO₂, ZrO₂, SnO₂, aluminum oxide type ceramics, zirconium oxide type ceramics, lead zirconium type ceramics, barium zirconate type ceramics, other metal zirconate type ceramics, lead complex oxide type ceramics and known dielectric ceramics. The dielectric ceramics may be used either singly or in combinations of two or more. Also, those obtained by surface-treating these dielectric ceramics by using inorganic or organic materials may be used. The dielectric ceramics having a high dielectric constant may have a sphere form, or forms of various block fragments and no particular limitation is imposed on the shape of the dielectric ceramics.

The average particle diameter of the dielectric ceramics used in the present invention is preferably in a range from 0.01 to 10µm. If the average particle diameter of the dielectric ceramics is less than 0.01µm, there is the case where the specific inductive capacity of the complex dielectric film is insufficiently improved by compounding the dielectric ceramics. Also, if the average particle diameter of the dielectric ceramics having a high dielectric constant exceeds 10µm, there is the case where it is difficult to uniformly disperse and mix this dielectric ceramics in the resin, so that irregularities derived from the particles appear on the surface of the complex dielectric film to lose smoothness of the surface of the film, with the result that the adhesion of the film to the substrate and the moisture resistance of the film are deteriorated. There is also the case where the dielectric characteristics of the film vary widely.

As the dielectric ceramics in the present invention, an inorganic-organic hybrid such as those like the following materials may be used. Specifically, the dielectric ceramics are rubbed to activate its surface and then mixed with a compound having an epoxy group or a carboxyl group under stirring, to prepare an inorganic-organic hybrid to which the above compound is firmly stuck, and this hybrid may be used as the dielectric ceramics.

Examples of the compound having an epoxy group include saturated chain hydrocarbon compounds having an epoxy group at its terminal or principal chain and fluorinated epoxy compounds obtained by substituting fluorine for hydrogen of these saturated chain hydrocarbons. Also, examples of the compound having a carboxyl group include carboxyl group-containing fluororesins which may be represented by the following formula.

H-(CF₂ -CF₂-CH₂-CHX)ₙ-(CF₂-CF₂-CH₂-CHY)ₘ-H

wherein X represents a carboxyl group-containing group and Y represents any one or a combination of a vinyl ether group, a vinyl ester group and a hydroxyl group.

### <Hardener>

A hardener is added to the heatcurable dielectric resin composition of the present invention according to the need. As the hardener, a hardener used usually as a hardener for epoxy resins may be added. Examples of such a hardener include amine type hardeners, acid anhydride type hardeners and phenol type hardeners. Specific examples of the hardener include aliphatic amines and aliphatic polyamines such as diethylenetriamine and triethylenetetramine, aliphatic polyamines containing aromatic ring, alicyclic and cyclic polyamines, aromatic amines such as diaminediphenylsulfone, aliphatic acid anhydrides, alicyclic acid anhydrides, aromatic acid anhydrides and halogen type acid anhydrides, trisphenol, phenol novolac, cresol novolac, bisphenol A novolac, bisphenol F novolac, phenols-dicyclopentadiene polymerization addition type resins, dihydroxynaphthalene novolac, polyvalent phenols with xylidene as a connecting group, phenol-aralkyl resins, naphthols, polyamide resins and modified products of these compounds, methylol group-containing initial condensates obtained by reacting phenol, urea, melamine or the like with formalin, basic active hydrgen compounds represented by dicyandiamide, tertiary amines such as tris(dimethylaminomethyl)phenol, imidazole, Lewis acids or Brønsted acid salts such as BF₃-amine complexes, polymercaptan type hardeners, isocyanates or block isocyanates and organic acid dihydrazide. Also, these hardeners may be used in combinations of two or more.

As to the amount of the hardener to be added, the hardener may be added in an amount of 20 parts by weight or less and preferably 10 parts by weight or less based on a total of 100 parts by weight of the dielectric ceramics, epoxy resin A and epoxy resin B according to the need for controlling heat curing speed suitable to working environment.

### <Heatcurable dielectric resin film>

The heatcurable dielectric resin film of the present invention is a flexible film obtained by molding the above heatcurable dielectric resin composition of the present invention into a film.

The above heatcurable dielectric resin film may be obtained, for example, by vaporizing a solvent from a liquid prepared by dissolving or dispersing the heatcurable dielectric resin composition in the solvent to thereby mold the composition into a film.

The method of producing the heatcurable dielectric resin film according to the present invention has the characteristics that the above solution is applied to the substrate and then dried at a temperature lower than the temperature at which the heatcurable dielectric resin composition is cured to thereby vaporize the solvent.

As the substrate, for example, a plastic film whose surface has been subjected to releasing treatment may be used. When the heatcurable dielectric resin film is applied to the plastic film whose surface has been subjected to releasing treatment to mold the composition into a film, the substrate is usually peeled from the film after the molding.

Examples of the plastic film that may be used as the substrate may include films such as a polyethylene terephthalate (PET) film, polyethylene film, polypropylene film, polyester film, polyimide film, alamide, capton or polymethylpentene. As the plastic film, those insoluble in an organic solvent contained in heatcurable resin solution are preferably used.

Also, the thickness of the plastic film used as the substrate is preferably 1 to 100µm and more preferably 1 to 50µm.

As the releasing treatment, releasing treatment in which silicone, wax or a fluororesin is applied to the surface of the substrate is preferably adopted.

Also, a metal foil may be used as the substrate to form a dielectric film on the metal foil. In this case, the metal foil used as the substrate may be used as the electrode of a capacitor.

As the method of applying the heatcurable resin solution to the substrate, a usual coating method may be used without any particular limitation. The solution may be applied using, for example, a roller method, spraying method or silk screen method.

In the production method of the present invention, the solution of the heatcurable resin is molded into a film by drying the solution at a temperature lower than the temperature at which the heatcurable resin is cured and therefore, the resulting complex dielectric film is in an uncured state. Therefore, this state has very higher flexibility than the cured state and therefore, the resulting complex dielectric film is easily handled. Such a dielectric film can be heat-cured by heating the film after it is incorporated into a substrate such as a printed circuit board. Also, when a light-sensitive resin is used, it could be patterned by selective exposure to light.

The method of producing the complex dielectric film of the present invention is not limited to the above methods according to the present invention. The complex dielectric film of the present invention may be produced by other methods. For example, the heatcurable resin composition containing the dielectric ceramics having a high dielectric constant is formed on the film by extrusion-molding using a calendering method. Also, the heatcurable resin composition may be molded into a film by heating the composition at a temperature lower than the temperature at which the composition is cured.

The extrusion-molded dielectric film may be formed by molding such that the composition is extruded on the above substrate.

Also, when a metal foil is used as the substrate, foils using copper, aluminum, brass, nickel or iron and also, foils of alloys of these metals or complex foils may be used as the metal foil. The metal foil may be subjected in advance to, for example, surface treatment or coating treatment using an adhesive according to the need.

It is preferable that after the above heatcurable resin solution is applied to the surface of the metal foil, the solution be dried at a temperature lower than the temperature at which the composition is cured. Also, in the case of extrusion-molding the solution on the metal foil, the solution is preferably extruded and dried at a temperature lower than the temperature at which the composition is cured.

Also, the dielectric film may be formed between metal foils. In this case, the heatcurable resin solution may be applied to the metal foil and dried at a temperature lower than the temperature at which the composition is cured and then another metal foil is laminated on the heatcurable resin film to form a dielectric film put in the condition that the dielectric film is sandwiched between these metal foils. Also, a dielectric film may be formed between the metal foils by extrusion-molding the solution so as to be interposed between these metal foils.

### <Paste composition for printing>

A printing paste composition according to the present invention is used for forming the heatcurable dielectric resin film layer on a predetermined position by printing a liquid prepared by dissolving or dispersing the heatcurable dielectric resin composition of the present invention in a solvent, on the predetermined position. The printing paste composition has the characteristics that it contains a solvent having a vapor pressure of 1 mmHg or less at 20°C in an amount exceeding 50% by volume based on all solvents and has a viscosity of 500 Pa·s or less at 25°C.

When the content of the above solvent is excessively smaller than the above range, there is the case where the behavior of the viscosity of the paste composition varies on a printing plate during printing, bringing about deteriorated printing ability.

Also, when the viscosity of the paste composition exceeds the above range, there is the case where the printed surface is so roughened that a small pattern cannot be printed.

The viscosity of the paste composition is preferably in a range from 200 to 10 Pa·s at 25°C.

It is more preferable that the thixotropic coefficient (TI value) of the printing paste composition of the present invention when measured at a rotating ratio of 10 is 2 or more. If the chixotropic coefficient is less than this value, there is the case where, when the paste is used to print by screen printing, a rise in the direction of the thickness of the print portion is poor, bringing about ununiform thickness of the print layer. The thixotropic coefficient (TI value) is more preferably in a range from 2.5 to 3.5.

According to the present invention, a heatcurable dielectric resin film can be prepared easily which is superior in handling characteristics in an uncured state and has flexibility enough to obtain high workability when it is incorporated into a substrate and can stand to use after cured, showing that it is highly reliable.

### BRIEF DESCRIPTION OF DRAWINGS

Fig. 1 is a view showing the shape of the surface of a film parallel to the direction of printing on a dielectric resin film layer formed using a screen printing paste in an example according to the present invention.
Fig. 2 is a view showing the shape of the surface of a film parallel to the direction of printing on a dielectric resin film layer formed using a screen printing paste in a comparative example according to the present invention.

### DETAILED DESCRIPTION OF THE INVENTION

The present invention will be explained in more detail by way of examples. However, these examples are not intended to be limiting of the present invention and various modifications may be practiced within the scope and spirit of the present invention.

### <Example 1>

A solution prepared by dissolving 14.79 g of a BPA (bisphenol A) type epoxy resin (trade name: "Eport YD6020", manufactured by Tohto Kasei Co., Ltd., epoxy equivalent: 3,000 to 5,000, glass transition point: 61°C) as an epoxy resin A in 42.24 g of methyl ethyl ketone, 11.16 g of 1,3-bis(N,N-diglycidylaminomethyl)cyclohexane (the number of functional groups: 4, viscosity: 2.1 Pa·s, epoxy equivalent: 105) as an epoxy resin B, 1.22 g of 2,4-diamino-6-(2'-methylimidazolyl-(1'))-ethyl-s-triazine as a curing catalyst and 154.80 g of barium titanate (average particle diameter: 1.16µm) as a dielectric ceramics were stirred at normal temperature under normal pressure for 30 minutes in an Ishikawa-type stirring milling machine to prepare a heatcurable dielectric resin composition.

The resulting heatcurable dielectric resin composition was applied to a 25-µm-thick polyethylene terephthalate (PET) film whose surface had been subjected to silicon releasing treatment, by using a 8-mills (1 mills: 1/1000 inch) doctor blade, allowed to stand at ambient temperature for 30 minutes and dried at 70°C for 30 minutes and in succession at 90°C for 10 minutes by using a hot air drier, to produce a heatcurable dielectric resin film which was put into an uncured state.

The amount of residual solvents in the heatcurable dielectric resin film was measured by gas chromatographic method to find that it was 1% by weight or less. Also, the content of barium titanate in the heatcurable dielectric film was calculated by the area method from a sectional photography taken by SEM (scanning electron microscope), to find that it was 49% by volume.

This heatcurable dielectric resin film was wound around a cylindrical metal rod, to find that even if it was wound around a metal rod 2 mm in diameter, no crack appeared to confirm that it had high flexibility as a film which had been uncured by drying (B stage).

In order to measure the dielectric constant and dissipation factor (tanδ) of the heatcurable dielectric resin film, the above heatcurable dielectric resin composition was applied to a 0.5-mm-thick copper plate (JIS H3100, C1100P) by using a 8-mills doctor blade, allowed to stand at ambient temperature for 30 minutes and dried at 70°C for 30 minutes, in succession at 90°C for 10 minutes and further at 190°C for 1 hour by using a hot air drier, to cure the film. Gold was vapor-deposited on the cured dielectric resin film to measure the dielectric constant and dissipation factor at 100 Hz to 10 MHz by using an Impedance/Gain-Phase Analyzer (trade name: 4194A, manufactured by Yokogawa-Hewlett-Packard, Ltd.), wherein the copper plate and the gold deposited layer were used as the electrodes. The results at 1 kHz are shown in Table 1.

### <Example 2>

49.54 g of a methyl ethyl ketone solution containing 40% by weight of a BPA type epoxy resin (trade name: "Epicoat 1256B40", manufactured by Japan Epoxy Resin Co., Ltd., epoxy equivalent: 7,800, weight average molecular weight: 48,000, hydroxyl value: 309, glass transition point: 98°C) as an epoxy resin A, 14.88 g of 1,3-bis(N,N-diglycidylaminomethyl)cyclohexane (the number of functional groups: 4, viscosity: 2.1 Pa·s, epoxy equivalent: 105) as an epoxy resin B, 1.62 g of 2,4-diamino-6-(2'-methylimidazolyl-(1'))-ethyl-s-triazine as a curing catalyst and 147.66 g of barium titanate (average particle diameter: 1.16µm) as a dielectric ceramics were stirred at normal temperature under normal pressure for 30 minutes in an Ishikawa-type stirring milling machine to prepare a heatcurable dielectric resin composition.

Using the resulting heatcurable dielectric resin composition, a heatcurable dielectric resin film was produced in the same manner as in Example 1. Also, the amount of residual solvents in the heatcurable dielectric resin film was measured in the same manner as in Example 1, to find that it was 1% by weight or less. Also, the content of barium titanate in the heatcurable dielectric film was calculated by the area method from a sectional photography taken by SEM (scanning electron microscope), to find that it was 41% by volume.

Like the dielectric resin film of Example 1, this heatcurable dielectric resin film had high flexibility. Also, the dielectric constant and dissipation factor of the heatcurable dielectric resin film were measured in the same manner as in Example 1. The results are shown in Table 1.

### <Example 3>

A solution prepared by using 14.88 g of a phenoxy resin (weight average molecular weight: 65,000, hydroxyl value: 320, epoxy equivalent: 12,200, glass transition point: 131°C) synthesized by reacting bisphenol A with 4,4'-dihydroxydibenzalacetone (melting point: 237°C) in a ratio of 4/6, as an epoxy resin A and by dissolving this phenoxy resin in 59.64 g of anone, 19.72 g of 1,3-bis(N,N-diglycidylaminomethyl)cyclohexane (the number of functional groups: 4, viscosity: 2.1 Pa·s, epoxy equivalent: 105) as an epoxy resin B, 1.62 g of 2,4-diamino-6-(2'-methylimidazolyl-(1'))-ethyl-s-triazine as a curing catalyst and 147.66 g of barium titanate (average particle diameter: 1.16µm) as a dielectric ceramics were stirred at normal temperature under normal pressure for 30 minutes in an Ishikawa-type stirring milling machine to prepare a heatcurable dielectric resin composition.

Using the resulting heatcurable dielectric resin composition, a heatcurable dielectric resin film was produced in the same manner as in Example 1. Also, the amount of residual solvents in the heatcurable dielectric resin film was measured in the same manner as in Example 1, to find that it was 1% by weight or less. Also, the content of barium titanate in the heatcurable dielectric film was calculated by the area method from a sectional photography taken by SEM (scanning electron microscope), to find that it was 41a by volume.

Like the dielectric resin film of Example 1, this heatcurable dielectric resin film had high flexibility. Also, the dielectric constant and dissipation factor of the heatcurable dielectric resin film were measured in the same manner as in Example 1. The results are shown in Table 1.

Also, a negative photomask for patterning was placed on a heatcurable dielectric resin film formed by applying the heatcurable dielectric resin composition to a copper plate and drying in the same manner as in Example 1. The thermally uncured film was exposed to light from a highpressure mercury lamp (manufactured by Oak Seisakusho (k.k.)) at a dose of 9,000 mJ/cm². After the exposure, the film was developed by spraying a 30°C mixed solvent of methyl diglycol/y-butyrolactone (ratio by weight of 75/25) at a pressure of 6 Kg/cm² to elute the unexposed portion, thereby carrying out patterning. It was confirmed from this fact that the obtained heatcurable dielectric resin film had light-sensitivity and could be patterned by exposure to light. It was also confirmed that when the resin film was cured at 190°C for 1 hour after developed/dried, it had the same dielectric constant and dissipation factor that the original heat curable dielectric resin film had.

### <Example 4>

A solution prepared by using 27.54 g of a phenoxy resin (epoxy equivalent: 15,000, weight average molecular weight: 40,000, hydroxyl value: 320, glass transition point: 150°C) synthesized by reacting 4,4'-dihydroxy-biphenyl (melting point: 274°C) with epichlorohydrin, as an epoxy resin A and by dissolving the phenoxy resin in 59.35 g of anone, 20.78 g of 1,3-bis(N,N-diglycidylaminomethyl)cyclohexane (the number of functional groups: 4, viscosity: 2.1 Pa·s, epoxy equivalent: 105) as an epoxy resin B, 2.26 g of 2,4-diamino-6-(2'-methylimidazolyl-(1'))-ethyl-s-triazine as a curing catalyst and 206.30 g of barium titanate (average particle diameter: 1.16µm) as a dielectric ceramics were stirred at normal temperature under normal pressure for 30 minutes in an Ishikawa-type stirring milling machine to prepare a heatcurable dielectric resin composition.

Using the resulting heatcurable dielectric resin composition, a heatcurable dielectric resin film was produced in the same manner as in Example 1. Also, the amount of residual solvents in the heatcurable dielectric resin film was measured in the same manner as in Example 1, to find that it was 1% by weight or less. Also, the content of barium titanate in the heatcurable dielectric film was calculated by the area method from a sectional photography taken by SEM, to find that it was 41% by volume.

Like the dielectric resin film of Example 1, this heatcurable dielectric resin film had high flexibility. Also, the dielectric constant and dissipation factor of the heatcurable dielectric resin film were measured in the same manner as in Example 1. The results are shown in Table 1.

### <Example 5>

200 g of barium titanate (average particle diameter: 1.16µm) used as the dielectric ceramics was treated at normal temperature under normal pressure for 30 minutes in an Ishikawa-type stirring milling machine for 4 hours to give mechanical friction to the ceramics. Then, a solution prepared by 10 g of 2-ethylhexyl glycidyl ether in 100 g of methylcarbitol was added to the ceramics and the mixture was stirred for 4 hours. After solvents were removed, the solid was washed with methyl ethyl ketone and dried to an inorganic-organic hybridized material. As to the confirmation of this hybridization, it was judged by confirming whether or not the resulting powder dispersed in methanol was precipitated promptly. Also, the amount of 2-ethylhexyl glycidyl ether to be stuck to barium titanate was confirmed to be 0.8% by weight from the result of TGA measurement of a weight reduction by heating.

A solution obtained by dissolving 14.79 g of a BPA type epoxy resin (trade name: "Eport YD6020", manufactured by Tohto Kasei Co., Ltd., epoxy equivalent: 3000 to 5,000) as an epoxy resin A in 42.24 g of methyl ethyl ketone, 11.16 g of 1,3-bis(N,N-diglycidylaminomethyl)cyclohexane (the number of functional groups: 4, viscosity: 2.1 Pa·s, epoxy equivalent: 105) as an epoxy resin B, 1.22 g of 2,4-diamino-6-(2'-methylimidazolyl-(1'))-ethyl-s-triazine as a curing catalyst and 154. 80 g of the above inorganic-organic hybridized material were stirred at normal temperature under normal pressure for 30 minutes in an Ishikawa-type stirring milling machine to prepare a heatcurable dielectric resin composition.

Using the resulting heatcurable dielectric resin composition, a heatcurable dielectric resin film was produced in the same manner as in Example 1. Also, the amount of residual solvents in the heatcurable dielectric resin film was measured in the same manner as in Example 1, to find that it was 1% by weight or less. Also, the content of barium titanate in the heatcurable dielectric film was calculated by the area method from a sectional photography taken by SEM, to find that it was 48% by volume.

Like the dielectric resin film of Example 1, this heatcurable dielectric resin film had high flexibility. Also, the dielectric constant and dissipation factor of the heatcurable dielectric resin film were measured in the same manner as in Example 1. The results are shown in Table 1.

**Table 1**

| | Example 1 | Example 2 | Example 3 | Example 4 | Example 5 |
|---|---|---|---|---|---|
| Dielectric Constant (1KHz) | 42 | 33 | 32 | 36 | 41 |
| tan δ (1KHz) | 0.019 | 0.013 | 0.022 | 0.013 | 0.020 |

It is understood from the results shown in Table 1 that each heatcurable dielectric resin film obtained in Examples 1 to 5 exhibits good dielectric characteristics.

### <Example 6> (Production of a heatcurable dielectric resin film on a PET film)

Each heatcurable dielectric resin composition prepared in Examples 1 to 5 was applied to a 25-pm-thick polyethylene terephthalate (PET) film whose surface had been subjected to releasing treatment using silicone, by using a lip reverse coater and dried in a tunnel furnace controlled at 40 to 80°C. A 30-µm-thick polyethylene film was laminated on the dried film of the resin composition. The laminate was made to pass through rolls whose gap was adjusted and the heatcurable dielectric resin film could be wound around a plastic tube having a diameter of 3 inch (76.2 mm). Also, the amount of residual solvents in the resulting heatcurable dielectric resin film was measured by a gas chromatographic method, to find that it was 1% by weight or less. It was therefore confirmed that a heatcurable dielectric resin film which had high flexibility and was easily handlable could be produced from each heatcurable dielectric resin composition prepared in Examples 1 to 5.

### <Example 7> (Production of a heatcurable dielectric resin film with a copper foil and a reliability test)

Each heatcurable dielectric resin composition prepared in Examples 1 to 5 was applied to a 12-µm-thick copper foil by using a lip reverse coater and dried in a tunnel furnace prepared at 40 to 80°C. A 30-µm-thick polyethylene film was laminated on the dried film of the resin composition. The laminate was made to pass through rolls whose gap was adjusted and the heatcurable dielectric resin film could be wound around a plastic tube having a diameter of 3 inch (76.2 mm). The amount of residual solvents in the resulting heatcurable dielectric resin film was measured by a gas chromatographic method, to find that it was 1% by weight or less. It was therefore confirmed that a heatcurable dielectric resin film with a copper foil which had high flexibility and was easily handlable could be produced from each heatcurable dielectric resin composition prepared in Examples 1 to 5.

Each heatcurable dielectric resin film with a copper foil which was obtained here from each heatcurable resin composition prepared in Examples 1 to 5 was laminated on a substrate and cured in the following condition by using a vacuum heat press manufactured by Meiki Seisakusho. The resulting laminate was subjected to a reliability test shown in Table 2, to confirm all these materials could be put to practical use.
Vacuum sucking: several mm Hg at normal temperature
Temperature rise rate: 10°C/min
Pressure: 2 to 4 MPa
Retention on the course of the test: 10 minutes at 130°C
Final curing condition: 190°C/1 hour

**Table 2**

| Items | Test Method |
|---|---|
| Chemical Resistance | JIS C 5012-8.5.11 |
| Peeling Strength | JIS C 5012-8.1 |
| Pad Pull Strength | JIS C 5012-8.2 |
| Solder Heat Resistance | JIS C 5012-10.4.1 |
| Reflow Heat Resistance | JIS C 5012-10.4.2 |
| Internal Connection Reliability | JIS C 5012-9.2 |
| Interlayer Withstand Voltage | JIS C 5012-7.5 / JIS C 5012-9.4 |
| Withstand Voltage between Circuits | JIS C 5012-7.4 / JIS C 5012-9.4 |
| Interlayer Insulation Resistance | JIS C 5012-7.8 / JIS C 5012-9.4 |
| Insulation Resistance between Circuits | JIS C 5012-7.7 / JIS C 5012-9.4 |

### <Example 8> (Preparation of a screen printing paste)

A solution prepared by dissolving 14.79 g of a BPA (bisphenol A) type epoxy resin (trade name: "Eport YD6020", manufactured by Tohto Kasei Co., Ltd., epoxy equivalent: 3,000 to 5,000) as an epoxy resin A in 42.24 g of a mixed solvent of butylcarbitol (vapor pressure at 20°C: 0.01 mmHg)/anone (vapor pressure at 20°C: 3.0 mmHg) in the ratio of 6/4, 11.16 g of 1,3-bis(N,N-diglycidylaminomethyl)cyclohexane (the number of functional groups: 4, viscosity: 2.1 Pa·s, epoxy equivalent: 105) as an epoxy resin B, 1.22 g of 2,4-diamino-6-(2'-methylimidazolyl-(1'))-ethyl-s-triazine as a curing catalyst and 154.80 g of barium titanate (average particle diameter: 1.16µm) as a dielectric ceramics were stirred at normal temperature under normal pressure for 30 minutes in an Ishikawa-type stirring milling machine to prepare a heatcurable dielectric resin composition.

Organic bentonite (average particle diameter: 0.8µm) was added as a thixotropy-imparting agent to the heatcurable dielectric resin composition in an amount of 2% by weight based on the nonvolatile content (components other than solvents) contained in the heatcurable dielectric resin composition. A mixed solvent of butylcarbitol (vapor pressure at 20°C: 0.01 mmHg)/anone (vapor pressure at 20°C: 3.0 mmHg) in a ratio of 6/4 was added to the mixture, which was then mixed under stirring to adjust the viscosity of the mixture to 30 Pa·s at ambient temperature which viscosity was measured 5 rotations/min to obtain a screen printing paste. The thixotropic coefficient (TI value) that was the ratio of the viscosity measured at a rotation of 0.5/min to the viscosity measured at a rotation of 5/min was 2.6.

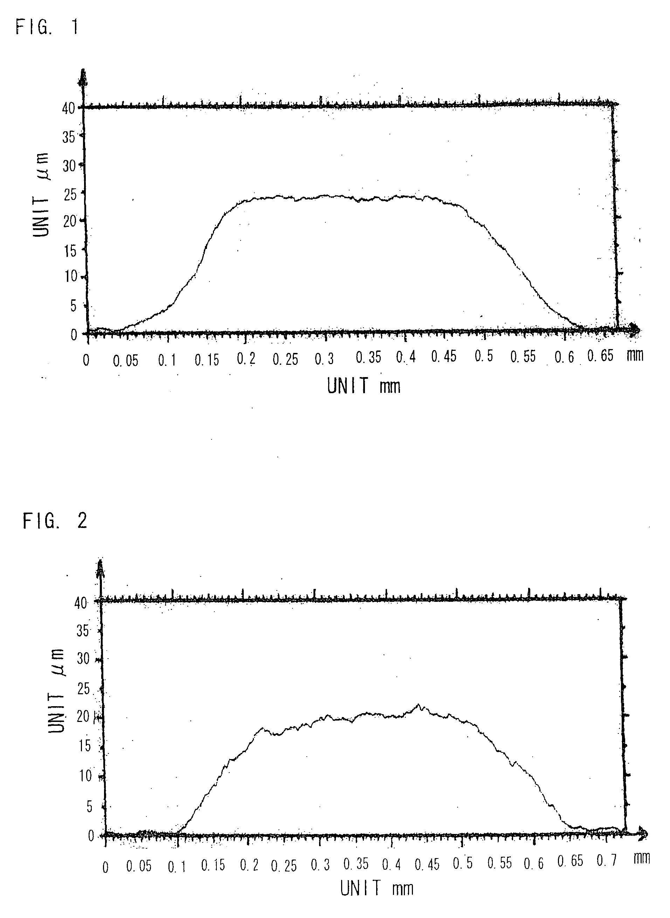

When the obtained screen printing paste was used to carry out printing using a 200-mesh screen plate, problems concerning, for example, clogging did not arise, even if 120 shots were taken by printing. Also, the printed dielectric resin film layer had a constant film thickness as shown in Fig. 1. Fig. 1 shows the surface shape of the film in the direction parallel to the direction of printing.

### <Comparative Example 1> (Comparative Example using a liquid epoxy resin in place of the epoxy resin A)

A solution obtained by dissolving 26.29 g of a liquid BPA type epoxy resin (trade name: "Eport YD128S", manufactured by Tohto Kasei Co., Ltd., epoxy equivalent: 205 to 225, viscosity 19 to 24 Pa·s, liquid at normal temperature) in 50.00 g of methyl ethyl ketone, 19.84 g of 1,3-bis(N,N-diglycidylaminomethyl)cyclohexane (the number of functional groups: 4, viscosity: 2.1 Pa·s, epoxy equivalent: 105), 2.16 g of 2,4-diamino-6-(2'-methylimidazolyl-(1'))-ethyl-s-triazine as a curing catalyst and 275.20 g of barium titanate (average particle diameter: 1.16µm) as a dielectric ceramics were stirred at normal temperature under normal pressure for 30 minutes in an Ishikawa-type stirring milling machine to prepare a heatcurable dielectric resin composition.

It was intended to produce a heatcurable dielectric resin film by using the resulting heatcurable dielectric resin composition in the same manner as in Example 1. However, a continuous film could not be formed.

### <Comparative Example 2> (Comparative Example using an epoxy resin having a viscosity higher than 10 Pa_{'}s at 25°C in place of the epoxy resin B)

A solution obtained by dissolving 16.43 g of a BPA type epoxy resin (trade name: "Eport YD6020", manufactured by Tohto Kasei Co., Ltd., epoxy equivalent: 3,000 to 5,000 in 45.14 g of methyl ethyl ketone, 11.53 g of Epicoat 828EL (number of functional groups: 2, viscosity: 13 Pa·s, epoxy equivalent: 186), 1.36 g of 2,4-diamino-6-(2'-methylimidazolyl-(1'))-ethyl-s-triazine as a curing catalyst and 172.00 g of barium titanate (average particle diameter: 1.16µm) as a dielectric ceramics were stirred at normal temperature under normal pressure for 30 minutes in an Ishikawa-type stirring milling machine to prepare a heatcurable dielectric resin composition.

Using the resulting heatcurable dielectric resin composition, a heatcurable dielectric resin film was produced in the same manner as in Example 1 and wound around a cylindrical metal rod and as a result, cracks appeared in the case of metal rods having a diameter of 8 mm or less.

### <Comparative Example 3> (Comparative Example in which the thixotropic coefficient was made to be a value less than 2 by changing the ratio of a solvent in Example 8 to 4/6 from 6/4)

A solution prepared by dissolving 14.79 g of a BPA (bisphenol A) type epoxy resin (trade name: "Eport YD6020", manufactured by Tohto Kasei Co., Ltd., epoxy equivalent: 3,000 to 5,000) as an epoxy resin A in 42.24 g of a mixed solvent of butylcarbitol (vapor pressure at 20°C: 0.01 mmHg)/anone (vapor pressure at 20°C: 3.0 mmHg)in the ratio of 6/4, 11.16 g of 1,3-bis(N,N-diglycidylaminomethyl)cyclohexane (the number of functional groups: 4, viscosity: 2.1 Pa·s, epoxy equivalent: 105) as an epoxy resin B, 1.22 g of 2,4-diamino-6-(2'-methylimidazolyl-(1'))-ethyl-s-triazine as a curing catalyst and 154.80 g of barium titanate (average particle diameter: 1.16µm) as a dielectric ceramics were stirred at normal temperature under normal pressure for 30 minutes in an Ishikawa-type stirring milling machine to prepare a heatcurable dielectric resin composition.

A mixed solvent of butylcarbitol (vapor pressure at 20°C: 0.01 mmHg)/anone (vapor pressure at 20°C: 3.0 mmHg) in a ratio of 4/6 was added to the mixture, which was then mixed under stirring to adjust the viscosity of the mixture to 30 Pa·s at ambient temperature which viscosity was measured 5 rotations/min to obtain a screen printing paste. The thixotropic coefficient (TI value) that was the ratio of the viscosity measured at a rotation of 0.5/min to the viscosity measured at a rotation of 5/min was 1.2.

When the obtained screen printing paste was used to carry out printing in the same manner as in Example 8, clogging occurred when 30 shots were taken by printing. Also, the printed dielectric resin film layer had uneven film thickness as shown in Fig. 2.

## Claims

1. A heatcurable dielectric resin composition for preparing a flexible heatcurable dielectric resin film having an uncured state, the resin film comprising:
an epoxy resin A having a solid state at normal temperature and an epoxy resin B having a viscosity of 10 Pa·s or less at 25°C in a ratio (A : B) by weight of 25 : 75 to 75 : 25, and further comprising a dielectric ceramics in an amount of 20 to 80 vol% based on the total amount of the epoxy resins A and B.

2. The heatcurable dielectric resin composition according to claim 1, wherein the number of functional groups of said epoxy resin B is 2 or more in its molecule.

3. The heatcurable dielectric resin composition according to claim 1, wherein the epoxy equivalent of said epoxy resin B is 200 or less.

4. The heatcurable dielectric resin composition according to claim 1, wherein said epoxy resin A has a glass transition point of 40°C or more.

5. The heatcurable dielectric resin composition according to claim 1, wherein the epoxy equivalent of said epoxy resin A exceeds 2500.

6. The heatcurable dielectric resin composition according to claim 1, wherein said epoxy resin A is a phenoxy resin having a weight average molecular weight of 25000 or more.

7. The heatcurable dielectric resin composition according to claim 6, wherein said phenoxy resin is a resin obtained by reacting epichlorohydrin with a compound having two or more hydroxyl groups and one or more photo-reacting groups in its molecule.

8. The heatcurable dielectric resin composition according to claim 7, wherein said photo-reacting group is α,β-unsaturated ketone group and/or benzophenone group.

9. The heatcurable dielectric resin composition according to claim 6, wherein said phenoxy resin is a resin obtained by reacting epichlorohydrin with a compound having a melting point of 200°C or more and two or more hydroxyl groups in its molecule.

10. The heatcurable dielectric resin composition according to claim 6, wherein said phenoxy resin has a hydroxyl value of 200 or more.

11. The heatcurable dielectric resin composition according to claim 6, wherein said phenoxy resin has a glass transition point of 120°C or more.

12. The heatcurable dielectric resin composition according to claim 1, wherein said dielectric ceramics has an average particle diameter of 0.01 to 10µm.

13. The heatcurable dielectric resin composition according to claim 1, wherein said dielectric ceramics is a ferroelectric ceramics having a perovskite structure.

14. The heatcurable dielectric resin composition according to claim 1, wherein said dielectric ceramics is a dielectric ceramics prepared by rubbing a dielectric ceramics to activate the surface thereof and then by mixing the activated dielectric ceramics with a compound having an epoxy group with stirring to make the compound adhere to the surface of the dielectric ceramics firmly.

15. The heatcurable dielectric resin composition according to claim 14, wherein said compound having an epoxy group is a saturated chain type hydrocarbon compound having an epoxy group at its terminal or principal chain.

16. The heatcurable dielectric resin composition according to claim 14, wherein the compound having an epoxy group is a fluorinated epoxy compound obtained by substituting fluorine for hydrogen.

17. The heatcurable dielectric resin composition according to claim 1, wherein said dielectric ceramics is prepared by rubbing a dielectric ceramics to activate the surface thereof and then by mixing the activated dielectric ceramics with a compound having a carboxyl group with stirring to make the compound adhere to the surface of the dielectric ceramics firmly.

18. The heatcurable dielectric resin composition according to claim 17, wherein said compound having a carboxyl group is a compound represented by the following formula:
H-(CF₂-CF₂-CH₂-CHX)ₙ- (CF₂-CF₂-CH₂-CHY)ₘ-H
wherein X represents a carboxyl group-containing group and Y represents any one or a combination of a vinyl ether group, a vinyl ester group and a hydroxyl group.

19. A heatcurable dielectric resin film, the resin film having a flexibility and being obtained by molding the heatcurable dielectric resin composition as claimed in claim 1 into a film form.

20. The heatcurable dielectric resin film according to claim 19, wherein said heatcurable dielectric resin composition is molded into a film form by vaporizing a solvent from a solution in which the heatcurable dielectric resin composition is dissolved or dispersed.

21. A method of producing a heatcurable dielectric resin film, the method producing the heatcurable dielectric resin film as claimed in claim 20 and comprising applying said solution on a substrate and drying the applied solution at a temperature lower than the temperature at which the resin composition is cured to thereby vaporize said solvent.

22. A printing paste composition that is used to form a heatcurable dielectric resin film layer at a predetermined place by printing using a liquid in which the heatcurable dielectric resin composition as claimed in claim 1 is dissolved or dispersed in a solvent, the paste composition containing a solvent having a vapor pressure of 1 mmHg or less at 20°C in an amount of more than 50% by volume based on all solvents and a viscosity of 500 Pa·s or less at 25°C.

23. The printing paste composition according to claim 22, the paste composition having a thixotropic coefficient (TI value) of 2 or more measured at a rotation ratio of 10.
